# EUROPEAN PATENT SPECIFICATION

(11) **EP 3 264 110 B1**
(45) Date of publication and mention of the grant of the patent: **18.05.2022**
(21) Application number: 15883166.9
(22) Date of filing: 24.02.2015
(51) Int. Cl.: G01R 15/24, G01R 33/032

(54) **OPTICAL FIBER SENSOR AND MEASUREMENT DEVICE USING SAME**
GLASFASERSENSOR UND MESSVORRICHTUNG DAMIT
CAPTEUR À FIBRES OPTIQUES ET DISPOSITIF DE MESURE UTILISANT CE DERNIER

(43) Date of publication of application: 03.01.2018
(73) Proprietor: Hitachi, Ltd., Tokyo 100-8280 (JP)
(72) Inventor: ENDOU, Hisashi, Tokyo 100-8280 (JP); TAKAGI, Hiroyuki, Toyohashi-shi, Aichi 441-8580 (JP); GOTO, Taichi, Toyohashi-shi, Aichi 441-8580 (JP); INOUE, Mitsuteru, Toyohashi-shi, Aichi 441-8580 (JP)
(74) Representative: MERH-IP Matias Erny Reichl Hoffmann Patentanwälte PartG mbB
(86) International application number: PCT/JP2015/055298
(87) International publication number: WO 2016/135870

(56) References cited:
- WO-A1-2007/004691
- CN-A- 102 621 403
- JP-A- H04 190 164
- JP-A- H04 190 164
- JP-A- H05 312 843
- JP-A- 2004 264 872
- JP-A- 2006 170 983
- JP-A- 2007 178 791
- US-A1- 2003 133 657
- US-A1- 2006 126 990
- US-A1- 2012 164 321
- US-B1- 6 262 949

## Description

### Technical Field

The present invention relates to an optical fiber sensor used for evaluation of current and a magnetic field in an electric/electronic device, and a measurement device using the same.

### Background Art

To ascertain the operation of an electric/electronic device, it is necessary to observe an electric condition, such as a voltage or current, pertaining to elements configuring each function. For example, in an electric motor which is one of electric devices converting electric energy into a machine motion, generated torque and current are closely related to each other, and to ascertain the operation of this electric device or to control this electric device, current measurement is absolutely necessary. Examples of the method for evaluating the electric condition of electric/electronic devices include using similarity in voltage/current waveform during operation, using amplitude difference, using phase difference, and using a frequency component pattern corresponding to an operating state.

For example, in general, a method using electric resistance and a method using a magnetic field have widely been known in current measurement. In the method using electric resistance, a voltage value generated on both ends of resistance having known resistance value when current flows through the resistance is measured, and a current value is calculated from the voltage value according to Ohm's law. However, when high current is measured, Joule heat generated on the resistance element by current supply is increased, and the resistance value rises significantly due to the temperature rise. Therefore, in an electric device with several amperes of current or an electronic device operating for a long time, there is a concern of an increase in errors in converting a voltage value into a current value. On the other hand, with the method using a magnetic field, a magnetic field generated by current supply is measured, and the measured magnetic field is converted into current according to Ampere's law. Thus, this method has a feature of not causing the concern by the Joule heat as in the method using electric resistance. A magnetic sensor such as a coil or a Hall element is generally used for measuring a magnetic field, wherein the coil is mainly applied to an AC (high-frequency) magnetic field component, and the Hall element is mainly applied to a DC (low-frequency) magnetic field component. The measurement of a magnetic field using an interaction of light and magnetism, called a magneto-optic effect, can be applied to both a DC magnetic field component and an AC magnetic field component.

The magneto-optic effect is a phenomenon in which, when a magnetic material is irradiated with light, the polarization angle of the emitted light is rotated according to the magnetization state of the magnetic material. The phenomenon pertaining to reflection light on a target magnetized material has been well known as the Kerr effect, and the phenomenon pertaining to transmitted light has been well known as the Faraday effect. In the magneto-optic effect, as a method for measuring a magnetic field intensity using the Faraday effect, there is a method for measuring the intensity of a magnetic field caused by a current line to be measured by applying the magnetic field to an optical fiber and measuring an amount of rotation of the polarization angle of light passing through the optical fiber.

With respect to the measurement of a magnetic field using the magneto-optic effect described above, PTL 1 (JP 2001-281470 A) discloses a technology relating to an optical fiber characterized by including ferromagnetic particles.

### Citation List

### Patent Literature

PTL 1: JP 2001-281470 A

In US 2012/164321 A1 an electric field sensor is described which is obtained by directly forming an electro-optical film on a polished surface at a tip of an optical fiber by an aerosol position method.

In US 2003/133657 A1 a magneto-optic field sensor design is described.

In US 2006/126990 A1 a system for estimating a parameter selected from the group consisting of a current, a magnetic field or a combination thereof is described.

In JPH 04190164 A an optical fiber is provided with a slit so as to extend from the outer periphery to a core of the fiber. A polarization plane control element is inserted into the slit.

In US 6262949 B1 a multilayer resonance device including regularly stacked layers, each formed by alternately stacking a magnetic substance and a dielectric substance is described.

### Summary of the invention

### Technical problem

When a magnetic field caused by a current line to be measured is applied to an optical fiber and the intensity of the magnetic field and a current amount are measured by measuring the amount of rotation of the polarization angle of light passing through the optical fiber, the amount of rotation of the polarization angle relative to the magnetic field, that is, the sensitivity to the magnetic field, is determined by the distance of light passing through the magnetized material or the Verdet constant.

However, when the magnetic body having high Verdet constant is diffused in the optical fiber sensor to improve the polarization angle relative to the magnetic field intensity, that is, the sensitivity relative to the magnetic field intensity, as in the conventional technology disclosed in PTL 1 described above, magnetic particles attenuate the intensity of light passing through the optical fiber, resulting in entailing a problem such that the intensity of light passing through the optical fiber is reduced and the light reception sensitivity is degraded.

The present invention is accomplished in view of the above, and aims to provide an optical fiber sensor capable of suppressing light reception sensitivity degradation while enhancing magnetic field detection sensitivity, and a measurement device that uses the same.

### Solution to Problem

In order to achieve the foregoing object, the features of the independent claims are suggested. Preferred developments are in the dependent claims. An optical fiber is configured from a core for propagating light irradiated from a light source to a detector and a cladding formed on the outer periphery of the core. A magnetic body is disposed on the optical axis of the optical fiber, a first dielectric material array disposed on one side of the magnetic body in the optical axis direction, and a second dielectric material array disposed on the other side of the magnetic body in the optical axis direction.

### Advantageous Effects of Invention

According to the present invention, light reception sensitivity degradation can be suppressed while magnetic field detection sensitivity is enhanced.

### Brief Description of Drawings

[FIG. 1] FIG. 1 is a functional block diagram schematically illustrating the entire configuration of a measurement device according to a first embodiment.
[FIG. 2] FIG. 2 is a sectional view on a plane passing through an optical axis of an optical fiber sensor.
[FIG. 3] FIG. 3 is a view schematically illustrating a relation between a magnetic field applied to a magnetic body and a polarization angle of light passing through the magnetic body.
[FIG. 4] FIG. 4 is a view schematically illustrating a state where the polarization angle of passing light is changed due to application of a magnetic field, caused by current, to an optical fiber sensor.
[FIG. 5] FIG. 5 is a diagram illustrating a relation between an amount of rotation of the polarization angle of light passing through the magnetic body and magnetic field intensity applied to the magnetic body.
[FIG. 6] FIG. 6 is a diagram illustrating a relation between the thickness of the magnetic body in the optical axis direction and the polarization angle.
[FIG. 7] FIG. 7 is a view illustrating, as a comparison example relative to the present embodiment, a case in which incident light is incident on a configuration provided with only a magnetic body to obtain transmission light.
[FIG. 8] FIG. 8 is a view for describing a path of light in a detection unit in the optical fiber sensor according to the first embodiment.
[FIG. 9] FIG. 9 is a diagram illustrating a relation among the wavelength, reflectivity, and polarization angle of incident light on a magnetic photonic crystal film formed as one structural example of the detection unit according to the first embodiment.
[FIG. 10] FIG. 10 is a diagram illustrating a relation between an amount of rotation of the polarization angle of light passing through the optical fiber sensor and the intensity of a magnetic field applied to the detection unit in the optical fiber sensor according to the first embodiment.
[FIG. 11] FIG. 11 is a diagram illustrating one example of a case where the waveform of current calculated by a conversion unit is displayed on a display unit.
[FIG. 12] FIG. 12 is a diagram illustrating a relation between a material used for the magnetic body and responsive property relative to variation in the magnetic field.
[FIG. 13] FIG. 13 is a functional block diagram schematically illustrating configurations of a light emission unit and a light reception unit according to one modification.
[FIG. 14] FIG. 14 is a functional block diagram schematically illustrating configurations of a light emission unit and a light reception unit according to another modification.
[FIG. 15] FIG. 15 is a functional block diagram schematically illustrating the entire configuration of a measurement device according to a second embodiment.
[FIG. 16] FIG. 16 is a sectional view on a plane passing through an optical axis of an optical fiber sensor.
[FIG. 17] FIG. 17 is a diagram illustrating a relation among the wavelength, reflectivity, and polarization angle of incident light on a magnetic photonic crystal film formed as one structural example of a detection unit according to the second embodiment.
[FIG. 18] FIG. 18 is a diagram illustrating an example of displaying currents measured on two locations by optical fiber sensors.
[FIG. 19] FIG. 19 is a view schematically illustrating an arrangement of a three-phase electric motor and a measurement device according to a third embodiment.
[FIG. 20] FIG. 20 is a diagram illustrating one example of a current waveform obtained by measuring a current waveform of a three-phase electric motor with optical fiber sensors on three locations using light of three wavelengths.
[FIG. 21] FIG. 21 is a diagram illustrating an output example when abnormality occurs on current on a V-phase power supply line of the three-phase electric motor.
[FIG. 22] FIG. 22 is a view illustrating that a magnetic photonic crystal film configured from a first dielectric material array, a magnetic body, and a second dielectric material array is formed in advance and adhered to a core of an optical fiber.
[FIG. 23] FIG. 23 is a view illustrating a method for manufacturing an optical fiber sensor, wherein a second dielectric material array, a magnetic body, and a first dielectric material array are laminated on an end face of an optical fiber by a vapor deposition method to form a detection unit.
[FIG. 24] FIG. 24 is a view illustrating a state where an interference fringe of ultraviolet ray is radiated from the circumferential direction of an optical fiber.
[FIG. 25] FIG. 25 is a view illustrating a state where a hole is formed by putting a mask on an optical fiber.
[FIG. 26] FIG. 26 is a view illustrating a state where a magnetic body is formed in the formed hole.
[FIG. 27] FIG. 27 is a sectional view illustrating a state where the mask is put on the optical fiber.
[FIG. 28] FIG. 28 is a sectional view illustrating a state where a hole is formed on the optical fiber on which the mask is put.
[FIG. 29] FIG. 29 is a sectional view illustrating a state where a magnetic body is formed in the formed hole.

### Description of Embodiments

Embodiments of the present invention will be described below with reference to the drawings.

### <First Embodiment>

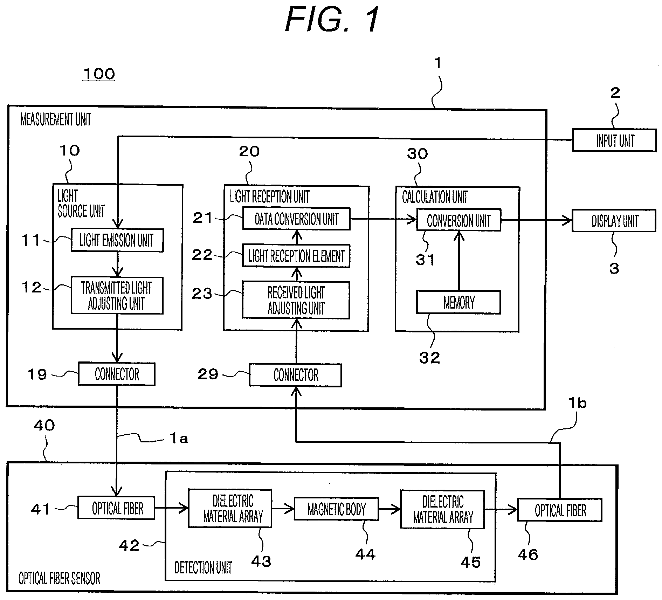

The first embodiment of the present invention will be described with reference to FIGS. 1 to 12.

FIG. 1 is a functional block diagram schematically illustrating the entire configuration of a measurement device according to the present embodiment.

In FIG. 1, a measurement device 100 schematically includes: a measurement unit 1 that performs transmission and reception of light used for measurement and a calculation process for a measured value; an input unit 2 that inputs various setting values and instruction signals to the measurement unit 1; a display unit 3 that displays the measured value which is the result of the calculation process by the measurement unit 1; and an optical fiber sensor 40 that allows transmitted light 1a from the measurement unit 1 to pass therethrough and transmits this light to the measurement unit 1 as received light 1b.

The measurement unit 1 includes: a light source unit 10 that generates light (transmitted light 1a) used for measurement and sends the generated light to the optical fiber sensor 40 through a connector 19; a light reception unit 20 that receives light (received light 1b) from the optical fiber sensor 40 through a connector 29; and a calculation unit 30 that performs a calculation process on the basis of the received light 1b received by the light reception unit.

The light source unit 10 includes a light emission unit 11 that generates light used for measurement on the basis of an instruction signal from the input unit 1, and a transmitted light adjusting unit 12 that transmits the light generated by the light emission unit 11 to the optical fiber sensor 40 through the connector 19 after adjusting the wavelength of the light and converting the light into a linearly polarized wave. The light emission unit 11 includes a white light source that emits visible light. In addition, the transmitted light adjusting unit 12 includes a wavelength selecting unit, such as a spectroscope or an interference filter, for extracting a prescribed wavelength from the light generated by the light emission unit 11, and a conversion unit for converting the light into a linearly polarized wave, and is able to generate light of at least one kind of wavelength. Note that a light emission diode or a laser diode can be used for the light emission unit 11 according to a specification of light to be generated.

The light reception unit 20 includes: a received light adjusting unit 23 that receives the received light 1b from the optical fiber sensor 40 through the connector 29 and selects and adjusts the received light 1b according to the wavelength or polarization angle; a light reception element 22 that receives light from the received light adjusting unit 23 and converts the received light into an electric signal; and a data conversion unit 21 that converts the electric signal obtained by the light reception element 22 into received data.

The received light adjusting unit 23 has a wavelength selecting unit, such as a spectroscope or an interference filter, for extracting a prescribed wavelength from the received light 1b. A photodiode or an avalanche diode is used for the light reception element 22, for example. The data conversion unit 21 converts the electric signal from the light reception element 22 into received data, and transmits the received data to the calculation unit 30.

The calculation unit 30 includes a conversion unit 31 that converts the received data from the light reception unit 20 into a current value or a magnetic field intensity, and a memory 32 that stores a conversion value used by the conversion unit 31. The conversion unit 31 stores, as a conversion value, a relation between the received data and current, a relation between the received data and a magnetic field, etc. which is experimentally obtained in advance from the result of experiments, simulations, etc. The conversion unit 31 converts the received data into a current value or the intensity of a magnetic field on the basis of the conversion value stored in the memory 32, and sends the converted value to the display unit 3 as a measured value.

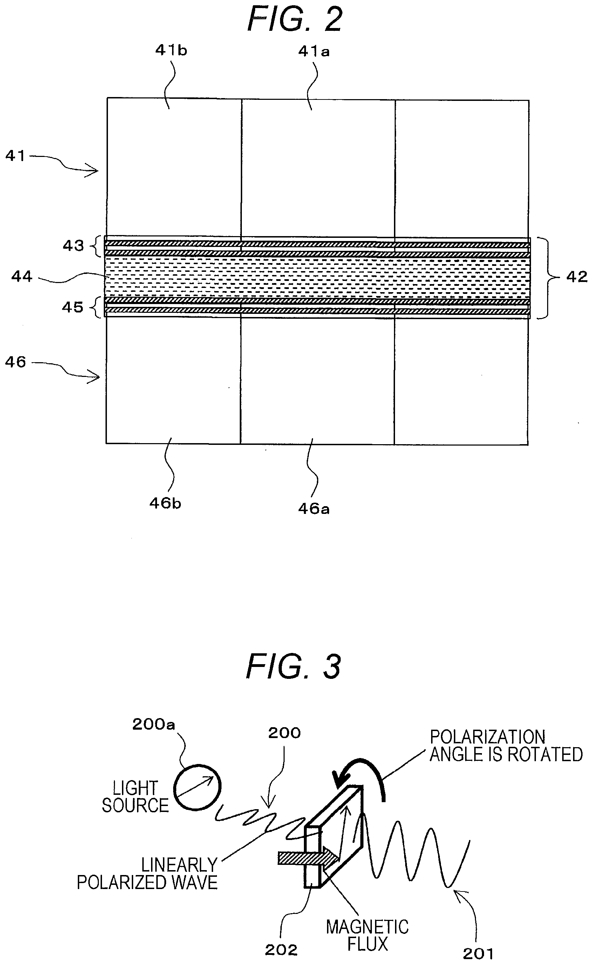

FIG. 2 is a sectional view on a plane passing through the optical axis of the optical fiber sensor, wherein the upper side is the light source unit side, and the lower side is the light reception unit side.

In FIGS. 1 and 2, the optical fiber sensor 40 is provided with: optical fibers 41 and 46 configured from cores 41a and 46a for propagating transmitted light 1a irradiated from the light source unit 10 to the light reception unit 20 and claddings 41b and 46b formed on the outer periphery of the cores 41a and 46a, a magnetic body 44 disposed on the optical axis of the optical fibers 41 and 46, a first dielectric material array 43 disposed on one side of the magnetic body 44 in the optical axis direction, and a second dielectric material array 45 disposed on the other side of the magnetic body 44 in the optical axis direction. In the optical fiber sensor 40, the first dielectric material array 43, the magnetic body 44, and the second magnetic body 45 are collectively referred to as a detection unit 42. The optical fibers 41 and 46 are formed from quartz glass, lead quartz glass, etc. The magnetic body 44 can be made of a metal called garnet having transparency, and is formed from Bi-substituted yttrium iron garnet, gadolinium iron garnet described later, etc. The dielectric material arrays 43 and 45 are formed by regularly arraying dielectric materials, each having a different refractive index, along the optical axis direction, and function as a dielectric mirror.

Herein, the principle of detecting a magnetic field by the optical fiber sensor 40 will be described with reference to FIGS. 3 to 9.

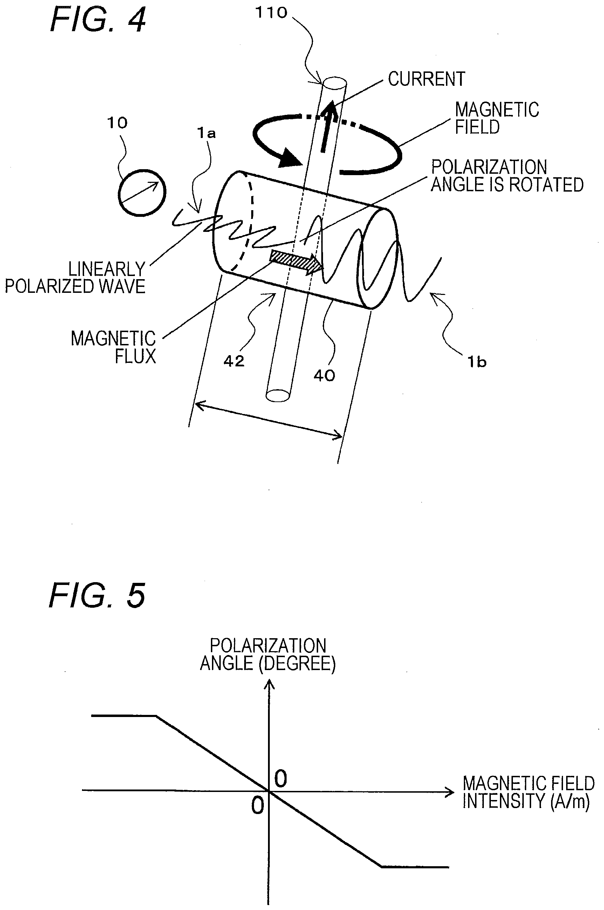

FIG. 3 is a view schematically illustrating a relation between the magnetic field applied to the magnetic body and the polarization angle of light passing through the magnetic body, and FIG. 4 is a view schematically illustrating a state where the polarization angle of the light passing through the magnetic body is changed due to the magnetic field caused by current being applied to the optical fiber sensor.

As illustrated in FIG. 3, when light which is linearly polarized passes through a magnetic body 202, the polarization angle is rotated and changed depending on the magnetization state of the magnetic body 202 due to the magneto-optical effect. This is called the Faraday effect. Specifically, when the magnetization state is changed by application of the magnetic field (magnetic flux) to the magnetic body 202, the magnetization state of the magnetic body 202 can be detected by detecting an amount of rotation of the polarization angle of transmission light 201 relative to incident light 200 which is generated by a light source 200a to be incident on the magnetic body 202, and thus, the intensity of the magnetic field applied to the magnetic body 202 can be detected.

As illustrated in FIG. 4, in the present embodiment, a linearly polarized wave generated from the light source unit 10 is incident on the optical fiber sensor 40 as the transmitted light 1a with the optical fiber sensor 40 being disposed near a current line 110 through which current to be measured flows, and the rotation of the polarization angle caused in the detection unit 42 by application of a magnetic field (magnetic field caused according to Ampere's rule) due to the current flowing through the current line 110 is detected from the received light 1b, whereby the magnetization state of the magnetic body 44 in the detection unit 42, that is, the intensity of the magnetic field applied to the magnetic body 44, can be detected.

FIG. 5 is a diagram illustrating the relation between the amount of rotation of the polarization angle of light passing through the magnetic body and the magnetic field intensity applied to the magnetic body, wherein the vertical axis indicates the polarization angle (degree) and the horizontal axis indicates the magnetic field intensity (A/m).

As illustrated in FIG. 5, in the magnetic body (magnetic thin film, etc.) showing the Faraday effect, the polarization angle varies in proportion to the magnetic field intensity. In addition, because a proportional relation is established between the magnetic field intensity and the current amount, current can be measured from the information of the polarization angle by acquiring in advance the relation between the magnetic field intensity and the polarization angle as illustrated in FIG. 5.

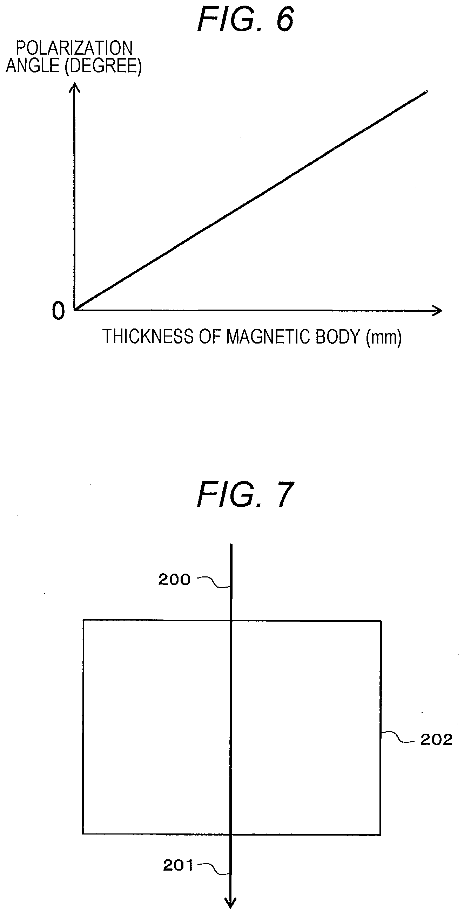

FIG. 6 is a diagram illustrating the relation between the thickness of the magnetic body in the optical axis direction and the polarization angle, wherein the vertical axis indicates the polarization angle (degree) and the horizontal axis indicates the thickness (mm) of the magnetic body.

As illustrated in FIG. 6, in the magnetic body showing the Faraday effect, the polarization angle increases in proportion to the thickness in the optical axis direction (that is, the optical path length in the magnetic body).

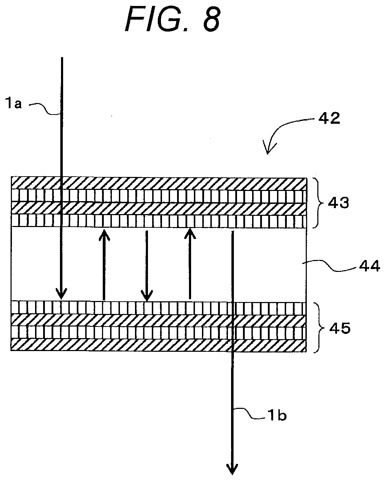

FIG. 8 is a view for describing a path of light in the detection unit in the optical fiber sensor according to the present embodiment.

In FIG. 8, the dielectric material arrays 43 and 45 of the optical fiber sensor 40 are formed by regularly arraying dielectric materials, each having a different refractive index, along the optical axis direction, and function as a dielectric mirror. The detection unit 42 has a configuration such that the magnetic body 44 is sandwiched between the dielectric material arrays 43 and 45 from both sides in the optical axis direction, and this configuration is referred to as a magnetic photonic crystal film. The dielectric material arrays 43 and 45 are formed by laminating tantalum pentoxide and silicon oxide. It is to be noted that, even if the tantalum pentoxide layer and the silicon oxide layer are switched in both the dielectric material arrays 43 and 45 serving as a dielectric mirror, the similar effect can be obtained.

The structure called microcavity configured by the dielectric material arrays 43 and 45 serving as a dielectric mirror has a property of transmitting or reflecting a specific wavelength. Specifically, reflectivity and transmittance can be changed so as to be dependent on the wavelength of light to be incident. Therefore, if the wavelength of light (transmitted light 1a) from which the rotation of the polarization angle is detected by the magnetic body 44 is determined, and the dielectric material arrays 43 and 45 serving as a dielectric mirror are designed to reflect light with this wavelength, light with a desired wavelength can be allowed to pass through the optical fiber sensor 40 to enable acquisition of information about the rotation of the polarization angle of the transmission light (received light 1b).

The transmitted light 1a incident on the detection unit 42 passes through the dielectric material array 43, is multiply reflected between the dielectric material arrays 43 and 45 serving as a dielectric mirror, passes through the dielectric material array 45, and is outputted as the received light 1b. Specifically, light is reflected a plurality of times between the dielectric material arrays 43 and 45, so that the distance of light in the magnetic body 44 (optical path length) is increased by the multiple reflection. Therefore, the effect similar to the effect obtained by increasing the thickness of the magnetic body 44 in the optical axis direction can be obtained.

FIG. 7 is a view illustrating, as a comparison example relative to the present embodiment, a case in which incident light is incident on a configuration provided with only a magnetic body to obtain transmission light.

In FIG. 7, a sensor using a conventional material has a configuration in which aluminum is provided in the form of a reflection plate 30 on one side of a magnetic layer showing the Faraday effect. A magnetic material layer 202 is formed from magnetic garnet, etc. A material is vapor deposited, incident light 200 is incident, and light 201 to be outputted can be obtained. The magnetic layer 202 is desirably formed to have a large thickness, because, the larger the thickness is, the larger the rotation of the polarization angle is, as described above.

On the other hand, the magnetic field caused by current has higher intensity as it is closer to the current region (electric line), and has smaller intensity as it is distant from the current region. Therefore, a technology is required to obtain a large polarization angle in a small region close to the current region.

In the detection unit 42 in the present embodiment, light propagating through the magnetic body 44 is reflected a plurality of times between the dielectric material arrays 43 and 45, so that the optical path length in the magnetic body 44 is increased by the number of times of reflection. Therefore, the polarization angle of the received light 1b relative to the transmitted light 1a is amplified. That is, even when the thickness of the magnetic body 44 is decreased, the rotation of the polarization angle equivalent to the case of increasing the thickness can be implemented, whereby the detection unit 42 can be formed in a smaller region and formed as close to the current line to be measured as possible.

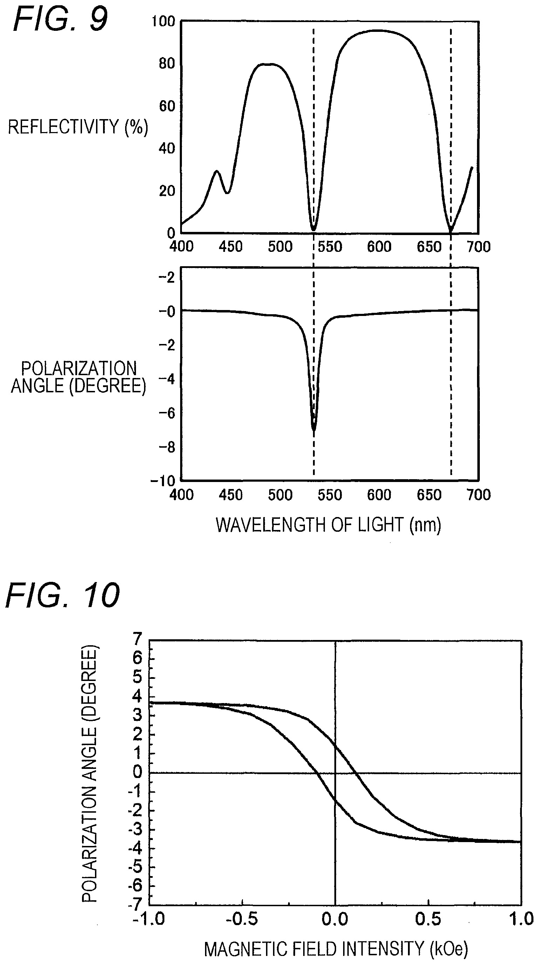

FIG. 9 is a diagram illustrating a relation among the wavelength, reflectivity, and polarization angle of the light incident on the magnetic photonic crystal film formed as one structural example of the detection unit in the present embodiment, wherein the vertical axis indicates the reflectivity (%) and polarization angle (degree), and the horizontal axis indicates the wavelength (nm) of the incident light.

As illustrated in FIG. 9, the reflectivity is nearly 0% at the wavelength of 540 nm at which the rotation of the polarization angle is the maximum. Specifically, this means that light with the wavelength of 540 nm is localized in the magnetic body 44 and the optical path of the light is increased, resulting in that the information of a magnetic field distribution with a large polarization plane rotation angle can be acquired. On the other hand, the reflectivity is low and the transmittance is high at the wavelength of 680 nm at which the rotation of the polarization angle is nearly 0 degree. This shows that, as for light with 680 nm, information of the polarization angle of light passing through the detection unit 42 is hardly changed.

FIG. 10 is a diagram illustrating the relation between the amount of rotation of the polarization angle of light passing through the optical fiber sensor in the present embodiment and the magnetic field intensity applied to the detection unit, wherein the vertical axis indicates the polarization angle (degree) and the horizontal axis indicates the magnetic field intensity (kOe).

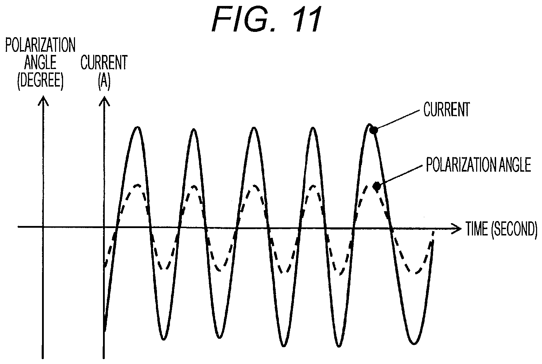

As illustrated in FIG. 10, when the relation between the amount of rotation of the polarization angle of the transmission light and the magnetic field intensity applied to the detection unit are obtained in advance and stored in the memory 32, current can be measured from the information of the polarization angle by the conversion unit 31 by utilizing the proportional relation being established between the magnetic field and current. The display unit 3 displays the waveform of the current calculated by the conversion unit as illustrated in FIG. 11.

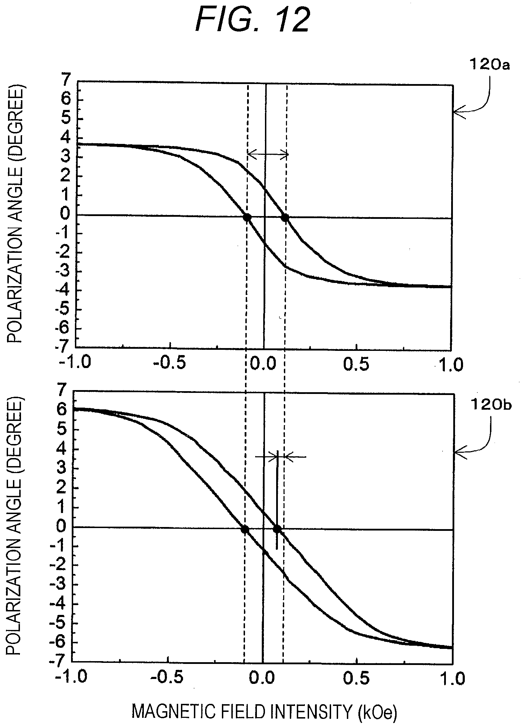

FIG. 12 is a diagram illustrating a relation between a material used for the magnetic body and responsive property relative to variation in the magnetic field intensity. In FIG. 12, a graph 120a indicates the relation between the magnetic field intensity and the polarization angle when yttrium iron garnet is used as the material of the magnetic body 44, and a graph 120b indicates the relation between the magnetic field intensity and the polarization angle when gadolinium iron garnet is used as the material of the magnetic body 44.

The magnetic body 44 has a non-linear response called hysteresis. This depends on the nature of the magnetic body called magnetic domain. In general, the magnetic body can be considered to be an assembly of magnets with small N poles and S poles, and a strong permanent magnet tends to have greater magnetic domain. On the other hand, the magnetic body has a feature in which, when having a great magnetic domain, the magnetic domain is not changed unless an externally applied magnetic field intensity is increased. Specifically, this means that, when the magnetic domain is great, variation in the polarization angle relative to variation in the magnetic field intensity is small, and therefore, responsiveness to the current which causes the magnetic field cannot be obtained. In view of this, the magnetic body 44 in the present embodiment is configured to include a material in which there is a distance between particle structures so that the magnetic body 44 does not have a magnetic domain structure. Particularly, a material called gadolinium iron garnet has weak bonding force between particle structures and excellent responsiveness relative to variation in current, i.e., variation in a magnetic field, and is excellent in variation in transmittance and polarization angle. When bismuth is added to gadolinium iron garnet, a material capable of further improving variation in the polarization angle can also be used.

As illustrated in FIG. 12, when gadolinium iron garnet is used as the material of the magnetic body 44 as shown in the graph 120b, magnetic coercive force involved with responsiveness is smaller than that of the magnetic body 44 formed by using yttrium iron garnet as shown in the graph 120a. Therefore, variation in the polarization angle can be obtained with lower magnetic field intensity.

The operation of the present embodiment thus configured will be described.

In the measurement device 100 according to the present embodiment, the detection unit 32 in the optical fiber sensor 40 is disposed near the current line 110 through which current to be measured flows. Next, when an instruction for measurement is issued from the input unit 2, light with a linearly polarized wave is generated from the light source unit 10 as the transmitted light 1a. This light is incident on the optical fiber 41 of the optical fiber sensor through the connector 19, and incident on the detection unit 42 through the optical fiber 41. Light with a predefined wavelength passes through and is multiply reflected on the first dielectric material array 43 and the second dielectric material array 45 of the detection unit 42, reciprocates in the magnetic body 44, and then, emitted to the optical fiber 46 as the received light 1b. At that time, the polarization angle of the light is rotated according to the magnetization state of the magnetic body 44 caused by the current flowing through the current line 110. Light with other wavelengths may be reflected without being incident on the detection unit 42 or may pass through without being multiply reflected in the detection unit 42, depending on the difference in wavelengths. The received light 1b emitted to the optical fiber 46 from the detection unit 42 is incident on the light reception unit 20 through the connector 29. The light reception unit 20 acquires data, such as the amount of variation in the polarization angle, obtained from the transmitted light 1a and the received light 1b, and the obtained data is sent to the calculation unit 30. The calculation unit 30 calculates the value of the current flowing through the current line 110 on the basis of the amount of variation in the polarization angle obtained from the transmitted light 1a and the received light 1b and the conversion value stored in advance in the memory 32, and the calculation result is displayed on the display unit 3.

The effect of the present embodiment thus configured will be described.

When a magnetic field caused by a current line to be measured is applied to an optical fiber and the intensity of the magnetic field and a current amount are measured by measuring the amount of rotation of the polarization angle of light passing through the optical fiber, the amount of rotation of the polarization angle relative to the magnetic field, that is, the sensitivity to the magnetic field, is determined by the distance of light passing through the magnetized material or the Verdet constant. However, when the magnetic body having high Verdet constant is diffused in the optical fiber sensor to improve the polarization angle relative to the magnetic field intensity, that is, the sensitivity relative to the magnetic field intensity, as in the conventional technology, magnetic particles attenuate the intensity of light passing through the optical fiber, resulting in entailing a problem such that the intensity of light passing through the optical fiber is reduced and the light reception sensitivity is degraded.

To address this problem, in the present embodiment, the optical fiber sensor 40 is configured which is provided with: the optical fibers 41 and 46 configured from the cores 41a and 46a for propagating light irradiated from the light source unit 10 to the light reception unit 20 and claddings 41b and 46b formed on the outer periphery of the cores 41a and 46a; the magnetic body 44 disposed on the optical axis of the optical fibers 41 and 46; the first dielectric material array 43 disposed on one side of the magnetic body 44 in the optical axis direction; and the second dielectric material array 45 disposed on the other side of the magnetic body in the optical axis direction. Therefore, light is localized in the magnetic body, whereby the effective optical path length can be increased. Consequently, variation in the polarization angle can be increased with a thin film, and thus, light reception sensitivity degradation can be suppressed while magnetic field detection sensitivity is enhanced.

### <Modification of First Embodiment>

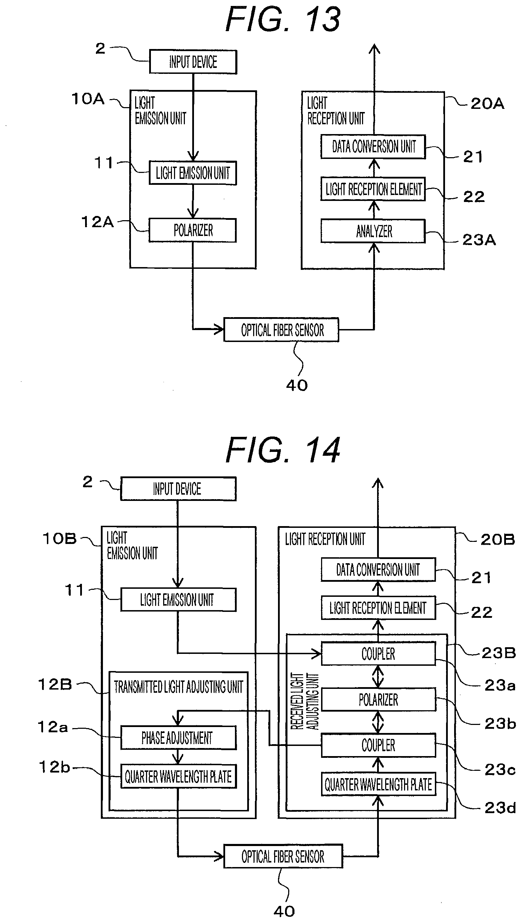

The modification of the first embodiment of the present invention will be described with reference to FIGS. 13 and 14.

FIG. 13 is a functional block diagram schematically illustrating configurations of a light emission unit and a light reception unit according to one modification, and FIG. 14 is a functional block diagram schematically illustrating configurations of a light emission unit and a light reception unit according to another modification.

As illustrated in FIG. 13, the effect similar to the effect obtained by the first embodiment can be obtained by the configuration provided with a light emission unit 10A and a light reception unit 20A using a polarizer 12A and an analyzer 23A in place of the transmitted light adjusting unit 12 in the light emission unit 10 and the received light adjusting unit 23 in the light reception unit 20 in the first embodiment.

Alternatively, as illustrated in FIG. 14, a transmitted light adjusting unit 12B provided with a phase adjustment unit 12a and a quarter wavelength plate 12b and a received light adjusting unit 23B provided with couplers 23a and 23c, polarizer 23b, and a quarter wave plate 23d are used in place of the transmitted light adjusting unit 12 in the light emission unit 10 and the received light adjusting unit 23 in the light reception unit 20 in the first embodiment, and a method can be used in which circularly polarized light is propagated through the optical fiber sensor 40 and the difference in polarization angle is extracted by causing interference by the coupler.

### <Second Embodiment>

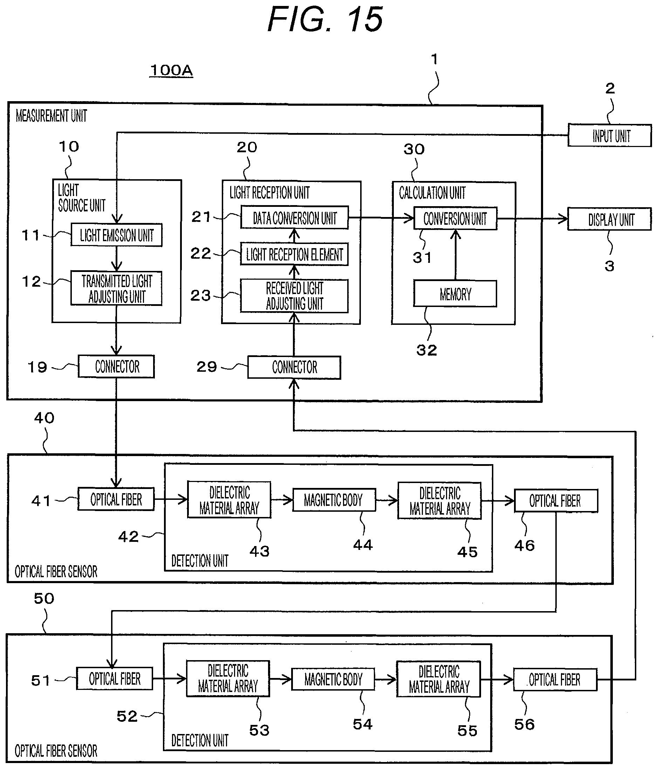

The second embodiment of the present invention will be described with reference to FIGS. 15 to 18.

In the present embodiment, current measurement is performed by disposing a plurality of (two in the present embodiment) optical fiber sensors on the same optical axis in series. In the drawings, components same as those in the first embodiment are identified by the same reference signs, and their description will be omitted.

FIG. 15 is a functional block diagram schematically illustrating the entire configuration of a measurement device according to the present embodiment.

In FIG. 15, a measurement device 100A schematically includes: a measurement unit 1 that performs transmission and reception of light used for measurement and a calculation process for a measured value; an input unit 2 that inputs various setting values and instruction signals to the measurement unit 1; a display unit 3 that displays the measured value which is the result of the calculation process by the measurement unit 1; and a plurality of (two in the present embodiment) optical fiber sensors 40 and 50 that allows transmitted light 1a from the measurement unit 1 to pass therethrough and transmits this light to the measurement unit 1 as received light 1b.

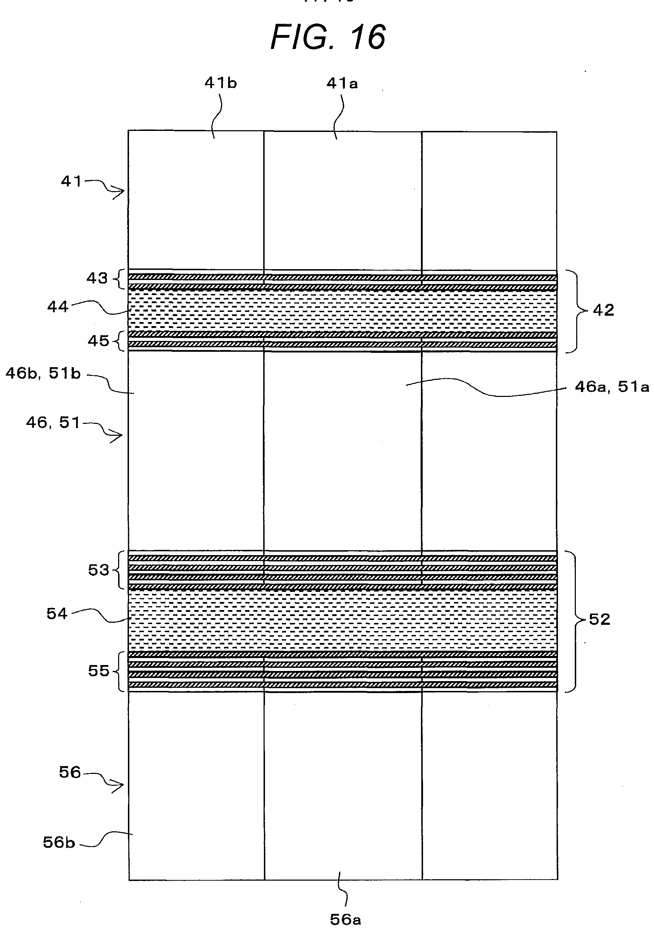

FIG. 16 is a sectional view on a plane passing through the optical axis of the optical fiber sensor, wherein the upper side is the light source unit side, and the lower side is the light reception unit side.

In FIGS. 15 and 16, the optical fiber sensor 40 is provided with: optical fibers 41 and 46 configured from cores 41a and 46a for propagating transmitted light 1a irradiated from the light source unit 10 and claddings 41b and 46b formed on the outer periphery of the cores 41a and 46a; a magnetic body 44 disposed on the optical axis of the optical fibers 41 and 46; a first dielectric material array 43 disposed on one side of the magnetic body 44 in the optical axis direction; and a second dielectric material array 45 disposed on the other side of the magnetic body 44 in the optical axis direction. In the optical fiber sensor 40, the first dielectric material array 43, the magnetic body 44, and the second magnetic body 45 are collectively referred to as a detection unit 42. The optical fibers 41 and 46 are formed from quartz glass, lead quartz glass, etc. The magnetic body 44 can be made of a metal called garnet having transparency, and is formed from Bi-substituted yttrium iron garnet, gadolinium iron garnet described later, etc. The dielectric material arrays 43 and 45 are formed by regularly arraying dielectric materials, each having a different refractive index, along the optical axis direction, and function as a dielectric mirror.

The optical fiber sensor 50 also has the similar structure, and is provided with: optical fibers 51 and 56 configured from cores 51a and 56a for propagating light through the optical fiber sensor 50 to a light reception unit 20 and claddings 51b and 56b formed on the outer periphery of the cores 51a and 56a; a magnetic body 54 disposed on the optical axis of the optical fibers 51 and 56; a third dielectric material array 53 disposed on one side of the magnetic body 54 in the optical axis direction; and a fourth dielectric material array 55 disposed on the other side of the magnetic body 54 in the optical axis direction. In the optical fiber sensor 50, the third dielectric material array 53, the magnetic body 54, and the fourth magnetic body 55 are collectively referred to as a detection unit 52. The optical fibers 51 and 56 are formed from quartz glass, lead quartz glass, etc. The magnetic body 54 can be made of a metal called garnet having transparency, and is formed from Bi-substituted yttrium iron garnet, gadolinium iron garnet described later, etc. The dielectric material arrays 53 and 55 are formed by regularly arraying dielectric materials, each having a different refractive index, along the optical axis direction, and function as a dielectric mirror.

Note that the optical fiber sensors 40 and 50 are disposed in series on the same optical axis, and the optical fiber 46 in the optical fiber sensor 40 and the optical fiber 51 in the optical fiber sensor 50 are integrally formed.

In the present embodiment, measurement on a plurality of points on the same optical axis is enabled by using the optical fiber sensors 40 and 50 which are different in the thickness of the dielectric material arrays and the thickness of the magnetic body and by changing a responding wavelength.

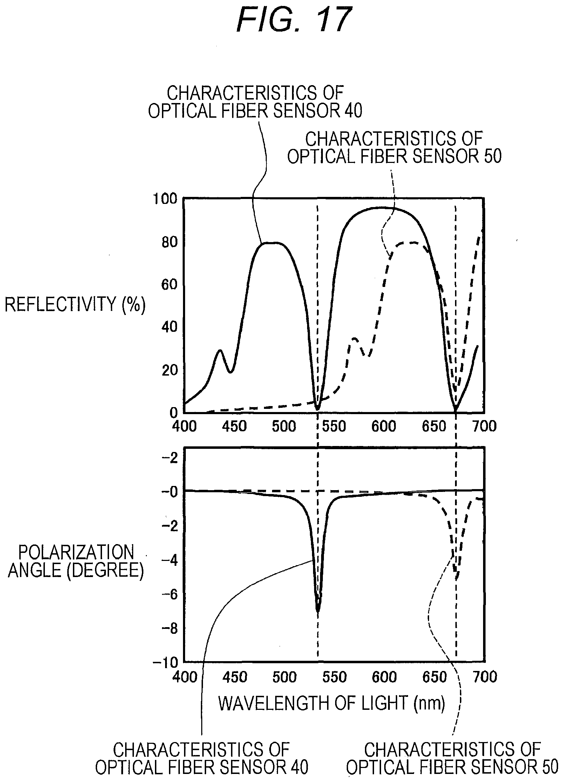

FIG. 17 is a diagram illustrating a relation among the wavelength, reflectivity, and polarization angle of light incident on a magnetic photonic crystal film formed as one structural example of the detection unit in the present embodiment, wherein the vertical axis indicates the reflectivity (%) and polarization angle (degree), and the horizontal axis indicates the wavelength (nm) of the incident light.

As illustrated in FIG. 17, in the characteristics of the detection unit 42, the reflectivity is nearly 0% at the wavelength of 540 nm at which the rotation of the polarization angle is the maximum. On the other hand, the reflectivity is low and the transmittance is high at the wavelength of about 680 nm at which the rotation of the magnetic field polarization angle is nearly 0 degree. In the characteristics of the detection unit 52, the thickness of the dielectric array materials and the thickness of the magnetic material layer are designed so that the polarization angle is amplified in this region. Such design is enabled by inputting the refractive index and the thickness of the material and simulating a polarization state depending on a wavelength according to a matrix method. When the sensor structure is designed according to this method, magnetic field information obtained by light with a wavelength of 540 nm according to the characteristics of the detection unit 42 and magnetic field information obtained by light with a wavelength of 680 nm according to the characteristics of the detection unit 52 can be acquired by a plurality of optical fiber sensors disposed on the same optical axis.

The other configurations are the same as those in the first embodiment.

According to the present embodiment configured as described above, the effect similar to the first embodiment can also be obtained.

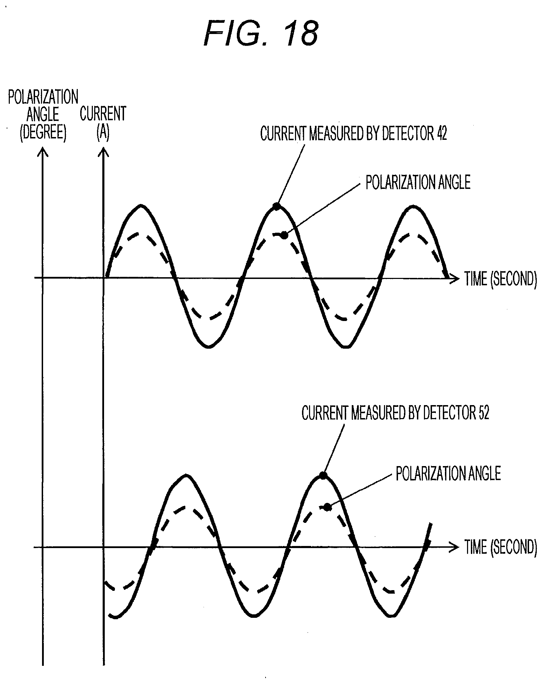

FIG. 18 is a diagram illustrating an example of displaying currents measured on two locations by the optical fiber sensors.

As illustrated in FIG. 18, when light with a plurality of wavelengths is used, and a plurality of detection areas (detection units 42 and 52) corresponding to the wavelengths are provided on the optical fiber sensors 40 and 50, current and magnetic field on a plurality of locations can be measured by the optical fiber system on the same line, whereby the number of optical fibers can be reduced. Thus, a measurement device having excellent measurement efficiency can be provided.

### <Third Embodiment>

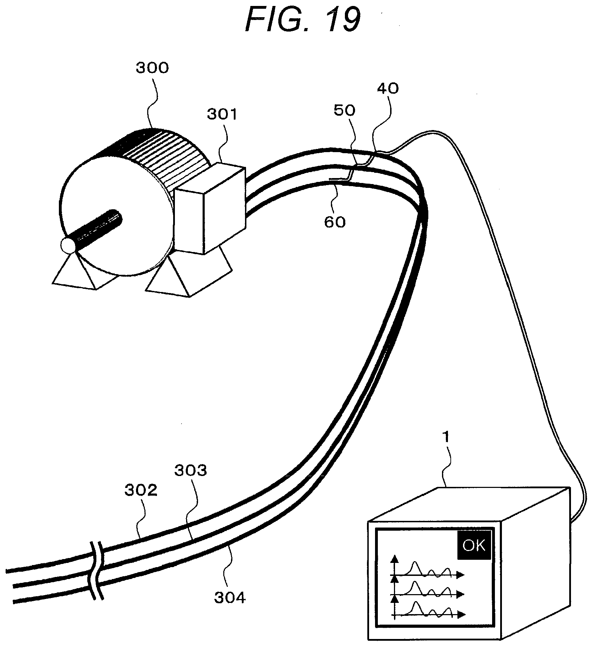

The third embodiment of the present invention will be described with reference to FIGS. 19 to 21.

The present embodiment describes a configuration in which the number of the optical fiber sensors in the second embodiment is changed to three to implement simultaneous measurement of currents of respective phases supplied to a three-phase electric motor. In the drawings, components same as those in the first and second embodiments are identified by the same reference signs, and their description will be omitted.

In FIG. 19, power from an unillustrated three-phase power supply is supplied to a three-phase electric motor 300 through a U-phase power supply line 302, a V-phase power supply line 303, and a W-phase power supply line 304 led from a power supply terminal box 301. The U-phase power supply line 302, the V-phase power supply line 303, and the W-phase power supply line 304 are respectively provided with optical fiber sensors 40, 50, and 60 which are connected to a measurement device 1.

Note that the optical fiber sensor 60 has the configuration similar to the configuration of the optical fiber sensors 40 and 50, and is disposed on the same optical axis. Specifically, following the second embodiment, the optical fiber sensor 60 is configured to have a detection unit whose dielectric array materials and magnetic material layer are designed to have a thickness so that a polarization angle is amplified at a frequency at which the reflectivity is low and the transmittance is high in the characteristics of the detection units 40 and 50 of the optical fiber sensors 40 and 50.

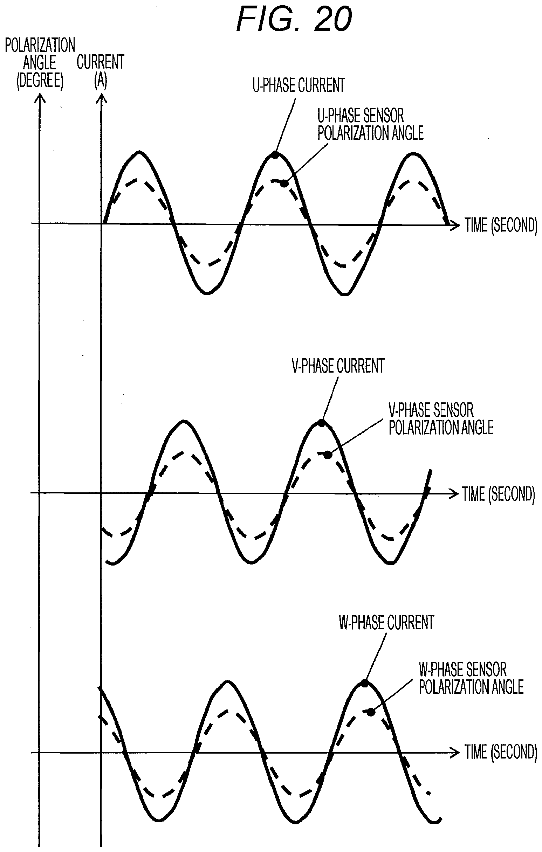

FIG. 20 is a diagram illustrating one example of a current waveform obtained by measuring a current waveform of the three-phase electric motor illustrated in FIG. 19 with optical fiber sensors 40, 50, and 60 on three locations using light of three wavelengths.

In the three-phase electric motor 300, the phase difference between the phases is 120 degrees, and an operating state can be monitored.

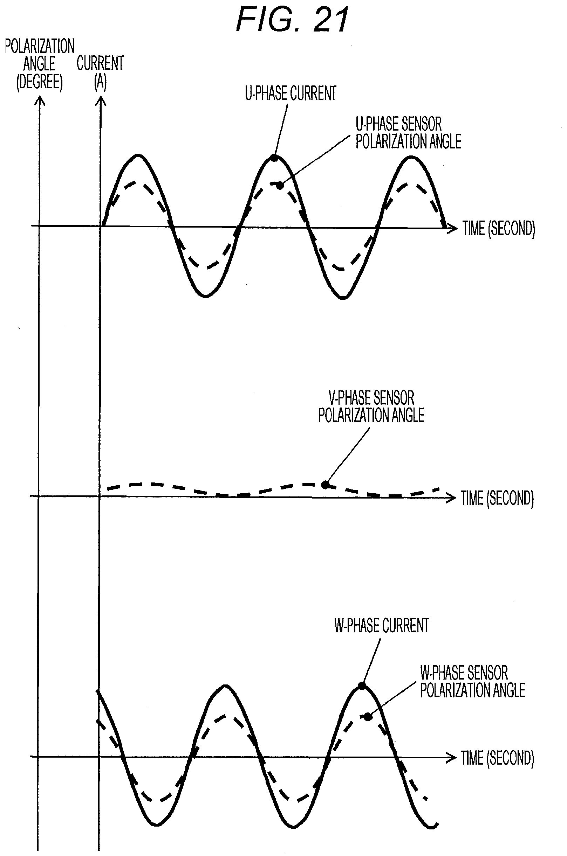

FIG. 21 is a diagram illustrating an output example when abnormality occurs on current on the V-phase power supply line of the three-phase electric motor.

When such abnormality occurs, it can be configured such that an abnormality in the amplitude balance is detected from the measurement result and an alarm indicating abnormality or the like is issued. This configuration can be used to warn of facility abnormality or stop the facility.

The other configurations are the same as those in the first and second embodiments.

According to the present embodiment configured as described above, the effect similar to the first and second embodiments can also be obtained.

### <Other Embodiments>

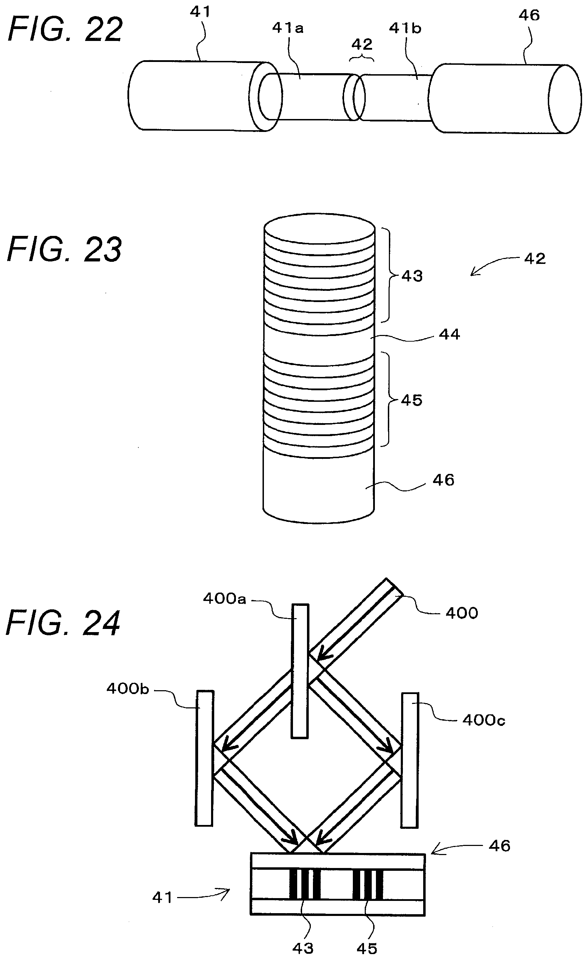

The other embodiments of the present invention will be described with reference to FIGS. 22 to 29.

The present embodiment relates to a method for manufacturing an optical fiber sensor.

FIG. 22 is a view illustrating that an element (magnetic photonic crystal film) configured from a first dielectric material array 43, a magnetic body 44, and a second dielectric material array 45 is formed in advance and adhered to cores 41a and 46a of optical fibers 41 and 46.

FIG. 23 illustrates a method for manufacturing an optical fiber sensor, wherein a second dielectric material array 45, a magnetic body 44, and a first dielectric material array 43 are laminated on the end face of an optical fiber 46 by a vapor deposition method to form a detection unit 42. According to this method, each material is vapor deposited on the end face of a plurality of optical fibers, which is bundled, to form a dielectric material array or a magnetic body, whereby optical fiber sensors having the same property can be mass-produced.

FIGS. 24 to 29 are views illustrating that a method for manufacturing a FBG (fiber bragg grating) sensor used for strain measurement is applied to process a dielectric material array.

As illustrated in FIGS. 24 to 26, an interference fringe of ultraviolet ray 400 is radiated using mirrors 400a, 400b, and 400c, or the like from the circumferential direction of optical fibers 41 and 46. Due to the irradiation of ultraviolet ray, the refractive indexes of the optical fibers 41 and 46 can be changed. The precision in the interference fringe interval is extremely high, so that the dielectric material arrays 43 and 45 can be implemented with a designed size with high precision.

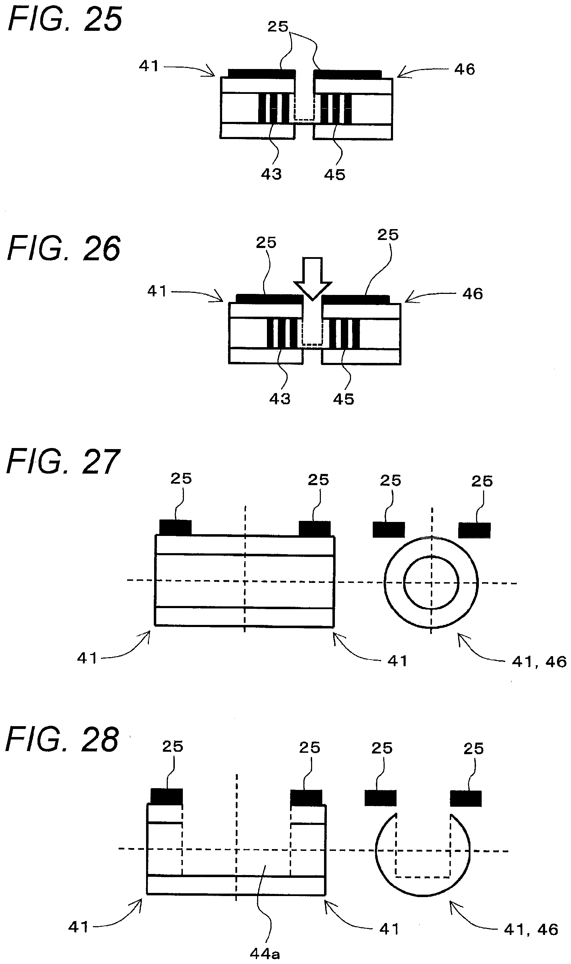

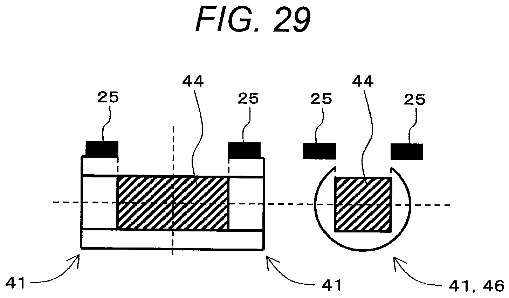

As illustrated in FIGS. 27 to 29, a hole is formed on the optical fibers 41 and 46 by putting a mask 25 thereon, and the magnetic body 44 can be embedded in the hole by a vapor deposition method. Firstly, the mask 25 is put on the optical fibers 41 and 46 (see FIG. 27), a hole is formed on the optical fibers 41 and 46 (see FIG. 28), and the magnetic body 44 is embedded (see FIG. 29). The length of the hole to be formed on the optical fibers in the axial direction can easily be changed by changing the range of the mask 25. Therefore, the distance of the magnetic body 44 through which light passes can easily be changed. That is, the thickness of the magnetic body 44 in the optical axis direction relative to the optical path can easily be changed. Note that the range requiring the magnetic body 44 is only a portion of the cores 41a and 46a of the optical fibers 41 and 46 through which light propagates. For example, if the core system has 10 nm, any thickness of the magnetic body 44 relative to the optical path can be implemented by the vapor deposition of the magnetic body 44 for a time for 10 nm.

By using this manufacturing method, a plurality of optical fibers can be arranged and processed, so that the size of the dielectric material arrays involved with wavelength characteristics can be implemented with high precision. Therefore, this method is effective to manufacture an optical fiber sensor provided with a plurality of current sensors (detection units) without forming a joint such as a connector.

### Reference Signs List

100, 100A measurement device
1 measurement unit
2 input unit
3 display unit
10 light source unit
20 light reception unit
30 calculation unit
40, 50, 60 optical fiber sensor
41, 46, 51, 56 optical fiber
42, 52 detection unit
43 first dielectric material array
44, 54 magnetic body
45 second dielectric material array
53 third dielectric material array
55 fourth dielectric material array

## Claims

1. An optical fiber sensor comprising:
an optical fiber (41, 46) configured from a core (41a, 46a) for propagating light irradiated from a light source disposed on one end to a detector disposed on the other end and a cladding (41a, 46a) formed on the outer periphery of the core (41a, 46a);
a magnetic body (44) disposed on an optical axis of the optical fiber (41, 46);
the optical fiber sensor **characterized in** further comprising:
a first dielectric material array (43) disposed on one side of the magnetic body (44) in the optical axis direction, the first dielectric material array (43) is formed by regularly arraying two or more kinds of dielectric materials, each having a different refractive index, along the optical axis direction; and
a second dielectric material array (45) disposed on the other side of the magnetic body (44) in the optical axis direction, the second dielectric material array (45) is formed by regularly arraying two or more kinds of dielectric materials, each having a different refractive index, along the optical axis direction; wherein
the magnetic body (44), the first dielectric material array (43), and the second dielectric material array (45) constitute a dielectric mirror for multiple reflections of light of a predetermined wavelength between the first dielectric material array (43) and the second dielectric material array (45).

2. The optical fiber sensor according to claim 1, wherein the first dielectric material array and the second dielectric material array are formed by regularly arraying tantalum pentoxide and silicon oxide along the optical axis direction.

3. The optical fiber sensor according to claim 1, wherein the magnetic body is gadolinium iron garnet (GdIG).

4. A measurement device comprising:
the optical fiber sensor according to claim 1;
a light source that emits light to one end of the optical fiber sensor;
a detector that detects light radiated from the other end of the optical fiber sensor; and
a magnetic field detection unit that detects a magnetic field applied to the magnetic body by detecting a magnetization state of the magnetic body on the basis of a polarization angle of light detected by the detector.

5. The measurement device according to claim 4 , wherein a first optical fiber sensor and a second optical fiber sensor which are different in thickness of the first dielectric material array, the second dielectric material array, and the magnetic body are connected in series.

6. The measurement device according to claim 4 , wherein a first optical fiber sensor, a second optical fiber sensor, and a third optical fiber sensor which are different in thickness of the first dielectric material array, the second dielectric material array, and the magnetic body are connected in series.

7. The optical fiber sensor according to claim 1 manufactured by bonding one end face of each of two optical fibers to both ends of a magnetic optical element which is formed by connecting the first dielectric material array and the second dielectric material array to both ends of the magnetic body in the optical axis direction.

8. The optical fiber sensor according to claim 1 manufactured such that: the first dielectric material array is deposited and formed on an end face of a first optical fiber; the magnetic body is deposited and formed on an end face of the first dielectric material array opposite to the first optical fiber; the second dielectric material array is deposited and formed on the end face of the magnetic body opposite to the first dielectric material array; and a second optical fiber is bonded to the end face of the second dielectric material array opposite to the magnetic body.

9. The optical fiber sensor according to claim 1 manufactured such that: ultraviolet ray is radiated for causing an interference fringe on the optical fiber to form the first dielectric material array and the second dielectric material array which are formed by regularly arraying two or more kinds of dielectric materials, each having a different refractive index, along the optical axis direction; a slit hole is formed between the first dielectric material and the second dielectric material; and a magnetic body is deposited in the slit hole.

## Patentansprüche

1. Faseroptischer Sensor, der Folgendes umfasst:
eine optische Faser (41, 46), die aus einem Kern (41a, 46a) zum Ausbreiten von Licht, das von einer Lichtquelle abgestrahlt wird, die an einem Ende angeordnet ist, zu einem Detektor, der an dem anderen Ende angeordnet ist, und einem Mantel (41a, 46a), der auf dem Außenumfang des Kerns (41a, 46a) gebildet ist, konfiguriert ist;
einen magnetischen Körper (44), der auf einer optischen Achse der optischen Faser (41, 46) angeordnet ist;
wobei der faseroptische Sensor **dadurch gekennzeichnet ist, dass** er ferner Folgendes umfasst:
eine erste Anordnung (43) aus dielektrischem Material, die auf einer Seite des magnetischen Körpers (44) in der Richtung der optischen Achse angeordnet ist, wobei die erste Anordnung (43) aus dielektrischem Material durch regelmäßiges Anordnen von zwei oder mehr Arten von dielektrischen Materialien, die jeweils einen unterschiedlichen Brechungsindex aufweisen, entlang der Richtung der optischen Achse gebildet ist; und
eine zweite Anordnung (45) aus dielektrischem Material, die auf der anderen Seite des magnetischen Körpers (44) in der Richtung der optischen Achse angeordnet ist, wobei die zweite Anordnung (45) aus dielektrischem Material durch regelmäßiges Anordnen von zwei oder mehr Arten von dielektrischen Materialien, die jeweils einen unterschiedlichen Brechungsindex aufweisen, entlang der Richtung der optischen Achse gebildet ist; wobei
der magnetische Körper (44), die erste Anordnung (43) aus dielektrischem Material und die zweite Anordnung (45) aus dielektrischem Material einen dielektrischen Spiegel für Mehrfachreflexionen von Licht einer vorgegebenen Wellenlänge zwischen der ersten Anordnung (43) aus dielektrischem Material und der zweiten Anordnung (45) aus dielektrischem Material bilden.

2. Faseroptischer Sensor nach Anspruch 1, wobei die erste Anordnung aus dielektrischem Material und die zweite Anordnung aus dielektrischem Material durch regelmäßiges Anordnen von Tantalpentoxid und Siliziumoxid entlang der Richtung der optischen Achse gebildet werden.

3. Faseroptischer Sensor nach Anspruch 1, wobei der magnetische Körper Gadolinium-Eisen-Granat (GdIG) ist.

4. Messvorrichtung, die Folgendes umfasst:
den faseroptischen Sensor nach Anspruch 1;
eine Lichtquelle, die Licht an ein Ende des faseroptischen Sensors abgibt;
einen Detektor, der Licht detektiert, das von dem anderen Ende des faseroptischen Sensors abgestrahlt wird; und
eine Magnetfeld-Detektionseinheit, die ein Magnetfeld detektiert, das an den magnetischen Körper angelegt wird, durch Detektieren eines Magnetisierungszustands des magnetischen Körpers auf der Grundlage eines Polarisationswinkels des Lichts, der durch den Detektor detektiert wird.

5. Messvorrichtung nach Anspruch 4, wobei ein erster faseroptischer Sensor und ein zweiter faseroptischer Sensor, die sich in der Dicke der ersten Anordnung aus dielektrischem Material, der zweiten Anordnung aus dielektrischem Material und dem magnetischen Körper unterscheiden, in Reihe verbunden sind.

6. Messvorrichtung nach Anspruch 4, wobei ein erster faseroptischer Sensor, ein zweiter faseroptischer Sensor und ein dritter faseroptischer Sensor, die sich in der Dicke der ersten Anordnung aus dielektrischem Material, der zweiten Anordnung aus dielektrischem Material und dem magnetischen Körper unterscheiden, in Reihe verbunden sind.

7. Faseroptischer Sensor nach Anspruch 1, der durch Bonden einer Stirnfläche von jeweils zwei optischen Fasern an beide Enden eines magnetischen optischen Elements hergestellt wird, das durch Verbinden der ersten Anordnung aus dielektrischem Material und der zweiten Anordnung aus dielektrischem Material mit beiden Enden des magnetischen Körpers in der Richtung der optischen Achse gebildet wird.

8. Faseroptischer Sensor nach Anspruch 1, der derart hergestellt wird, dass: die erste Anordnung aus dielektrischem Material auf einer Stirnfläche einer ersten optischen Faser aufgebracht und gebildet wird; der magnetische Körper auf einer Stirnfläche der ersten Anordnung aus dielektrischem Material gegenüber der ersten optischen Faser aufgebracht und gebildet wird; die zweite Anordnung aus dielektrischem Material auf der Stirnfläche des magnetischen Körpers gegenüber der ersten Anordnung aus dielektrischem Material aufgebracht und gebildet wird; und eine zweite optische Faser an die Stirnfläche der zweiten Anordnung aus dielektrischem Material gegenüber dem magnetischen Körper gebondet wird.

9. Faseroptischer Sensor nach Anspruch 1, der derart hergestellt wird, dass:
ultraviolette Strahlung abgestrahlt wird, um einen Interferenzstreifen auf der optischen Faser zu verursachen, um die erste Anordnung aus dielektrischem Material und die zweite Anordnung aus dielektrischem Material zu bilden, die durch regelmäßiges Anordnen von zwei oder mehr Arten von dielektrischen Materialien, die jeweils einen unterschiedlichen Brechungsindex aufweisen, entlang der Richtung der optischen Achse gebildet werden; ein Schlitzloch zwischen dem ersten dielektrischen Material und dem zweiten dielektrischen Material gebildet wird; und ein magnetischer Körper in dem Schlitzloch abgelegt wird.

## Revendications

1. Capteur à fibre optique comprenant :
une fibre optique (41, 46) configurée à partir d'une âme (41a, 46a) destinée à propager de la lumière irradiée depuis une source de lumière disposée sur une extrémité jusqu'à un détecteur disposé sur l'autre extrémité, et d'un placage (41a, 46a) formé sur la périphérie extérieure de l'âme (41a, 46a) ;
un corps magnétique (44) disposé sur un axe optique de la fibre optique (41, 46) ;
le capteur à fibre optique étant **caractérisé en ce qu'**il comprend en outre :
un premier agencement de matériaux diélectriques (43) disposé sur un côté du corps magnétique (44) dans la direction de l'axe optique, le premier agencement de matériaux diélectriques (43) étant formé en agençant régulièrement deux ou plusieurs sortes de matériaux diélectriques, ayant chacune un indice de réfraction différent, le long de la direction de l'axe optique ; et
un deuxième agencement de matériaux diélectriques (44) disposé sur l'autre côté du corps magnétique (44) dans la direction de l'axe optique, le deuxième agencement de matériaux diélectriques (45) étant formé en agençant régulièrement deux ou plusieurs sortes de matériaux diélectriques, ayant chacune un indice de réfraction différent, le long de la direction de l'axe optique ; dans lequel
le corps magnétique (44), le premier agencement de matériaux diélectriques (43) et le deuxième agencement de matériaux diélectriques (45) constituent un miroir diélectrique pour de multiples réflexions de lumière d'une longueur d'onde prédéterminée entre le premier agencement de matériaux diélectriques (43) et le deuxième agencement de matériaux diélectriques (45).

2. Capteur à fibre optique selon la revendication 1, dans lequel le premier agencement de matériaux diélectriques et le deuxième agencement de matériaux diélectriques sont formés en agençant régulièrement un pentoxyde de tantale et un oxyde de silicium le long de la direction de l'axe optique.

3. Capteur à fibre optique selon la revendication 1, dans lequel le corps magnétique est un grenat de gadolinium-gallium (GdIG).

4. Dispositif de mesurage comprenant :
le capteur à fibre optique selon la revendication 1 ;
une source de lumière qui émet de la lumière jusqu'à une extrémité du capteur à fibre optique ;
un détecteur qui détecte une lumière irradiée depuis l'autre extrémité du capteur à fibre optique ; et
une unité de détection de champ magnétique qui détecte un champ magnétique appliqué sur le corps magnétique en détectant un état d'aimantation du corps magnétique sur la base d'un angle de polarisation de la lumière détectée par le détecteur.

5. Dispositif de mesurage selon la revendication 4, dans lequel un premier capteur à fibre optique et un deuxième capteur à fibre optique, qui ont une épaisseur différente, du premier agencement de matériaux diélectriques, du deuxième agencement de matériaux diélectriques, et du corps magnétique sont connectés en série.

6. Dispositif de mesurage selon la revendication 4, dans lequel un premier capteur à fibre optique, un deuxième à fibre optique, et un troisième capteur à fibre optique, qui ont une épaisseur différente, du premier agencement de matériaux diélectriques, du deuxième agencement de matériaux diélectriques et du corps magnétique sont connectés en série.

7. Capteur à fibre optique selon la revendication 1 fabriqué en liant une face d'extrémité de chacune des deux fibres optiques aux deux extrémités d'un élément optique magnétique qui est formé en connectant le premier agencement de matériaux diélectriques et le deuxième agencement de matériaux diélectriques aux deux extrémités du corps magnétique dans la direction de l'axe optique.

8. Capteur à fibre optique selon la revendication 1 fabriqué de sorte que : le premier agencement de matériaux diélectriques est déposé et formé sur une face d'extrémité d'une première fibre optique ; le corps magnétique est déposé et formé sur une face d'extrémité du premier agencement de matériaux diélectriques en opposition à la première fibre optique ; le deuxième agencement de matériaux diélectriques est déposé et formé sur la face d'extrémité du corps magnétique en opposition au premier agencement de matériaux diélectriques : et une seconde fibre optique est liée à la face d'extrémité du deuxième agencement de matériaux diélectriques en opposition au corps magnétique.

9. Capteur à fibre optique selon la revendication 1 fabriqué de sorte que :
un rayon ultraviolet est irradié afin d'amener une frange d'interférence sur la fibre optique pour former le premier agencement de matériaux diélectriques et le deuxième agencement de matériaux diélectriques qui sont formés en agençant régulièrement deux ou plusieurs sortes de matériaux diélectriques, ayant chacune un indice de réfraction différent, le long de la direction de l'axe optique ; un trou en fente est formé entre le premier matériau diélectrique et le deuxième matériau diélectrique ; et un corps magnétique est déposé dans le trou en fente.
